# EUROPEAN PATENT APPLICATION

(11) **EP 1 447 844 A2**
(43) Date of publication of application: **18.08.2004**
(21) Application number: 03077862.5
(22) Date of filing: 28.08.2003
(51) Int. Cl.: H01L 23/31, H01L 23/00

(54) **Reinforced semiconductor wafer**

(30) Priority: 11.02.2003 EP 03290336
(71) Applicant: SCHLUMBERGER Systèmes, 92120 Montrouge (FR)
(72) Inventor: Audoux, Jean-No l, 92120 Montrouge (FR); Groeninck, Denis, 92120 Montrouge (FR)

(57) **Abstract**

A slice of semiconductor comprises an active face and an inactive face. At least one passivation layer is deposited on the active face. The inactive face is provided with an organic layer.

## Description

### Field of the invention

The invention concerns a slice of semiconductor comprising an active face and an inactive face. A passivation layer is deposited on the active face. The slice of semiconductor is, for example, a silicon wafer. The invention also concerns pieces of slice of semiconductor, for example, a chip. The invention can be applied, in particular in the semiconductor industry and in the smart card industry. In the context of an industrial process using wafer and microelectronic chip, every microelectronic packaging are concerned by this invention.

### Background of the invention

A wafer generally comprises an active face and inactive face. The active face is provided with active elements, for example, integrated circuit devices. The active face is also provided with contact pads.
The active face is generally already coated with a passivation layer in order to better protect the active face. A passivation layer generally comprises Si02 or Si3N4. Other well known material can be used.

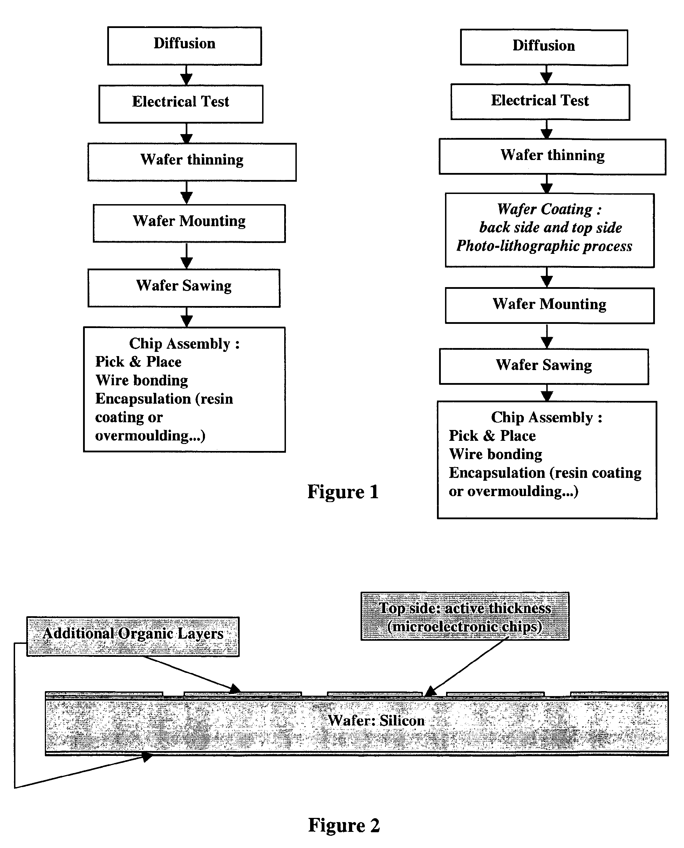

As illustrated in figure 1, standard smart card manufacturing process uses "naked" chip for microelectronic packaging, with process described as below:
- Wafer foundry, diffusion and testing.
- Wafer thinning.
- Wafer mounting.
- Wafer sawing.
- Chip pick & place on lead-frame or other package type.
- Wire bonding
- Resin coating or over moulding.

### Summary of the invention

It is an object of the invention to enhance the quality and to reduce the costs.

According to one aspect of the invention, a slice of semiconductor comprises an active face and an inactive face, a passivation layer being deposited on the active face, wherein the inactive face is provided with an organic layer.

The slice of semiconductor is, for example, a silicon wafer. The organic layer can be, for example, a polyimide, a thermic curing resin (epoxy basis), UV curing resin, an adhesive ("scotch") or a glue.
The organic-layer-depositing step can be introduced, for example, between the wafer-thinning step and the wafer-mounting step.
Silicon is a very brittle material, especially for thin chip application. During most of the above-mentioned manufacturing steps, the silicon is made fragile due to mechanical constraints faced, so chip breakage risk is very high. In order to increase chip reliability, chipping and crack on chip (or wafer) edges must be minimised, and the chip must be reinforced too.
By providing the inactive face of the wafer with an organic layer, a composite structure (organic/mineral/organic) is obtained. Therefore the mechanical stress induced by the passivation layer on the active face is reduced. The organic layer compensates the initial wafer stress. Thus the wafer bow and warping is reduced. The flatness of the wafer is therefore improved.
By providing the inactive face with an organic layer, chipping and crack propagation into silicon during wafer mounting, wafer sawing and pick & place steps is also reduced. The thus obtained chips have a composite structure (organic / mineral / organic) so that they are more rigid. Then, due to this global mechanical behaviour improvement, the lifetime of the final product, for example, a smart card, is significantly increased. During, for example, the "3wheels" test as defined in the ISO standards 7810 and 10373.1, the stress applied on the chip is reduced by 9%.
According to another advantage of the invention, the organic layer is made of an organic material. Thus the depositing step can be done using just a spin coating process, which is easy to implement and cost effective.
Thus the invention allows a reduction of the cost and an enhanced quality.

### Detailed description

According to another aspect of the invention, a second organic layer can be deposited on the passivation layer of the wafer so that the wafer bow and warping are more reduced. Advantageously the second organic layer is made of a photo sensitive resin using, for example, a photo-lithographic process (photo sensitive resin coating by liquid spinning, curing, exposure, development, etc...). Using a photo sensitive material enables to create opening within the second organic above the contact pads of the active surface.

According to another aspect of the invention, the second organic layer can be deposited of on a shielding layer which has been placed on the active face of the wafer. Advantageously the shielding layer is made of the same material than the wafer. Advantageously, the shielding layer is provider with holes being located flush with at least one integrated circuit element of the active face of the wafer.

The description hereinbefore illustrates a slice of semiconductor comprising an active face and an inactive face. A passivation layer is deposited on the active face. The inactive face is provided with an organic layer.

The slice of semiconductor is, for example, made of silicon. It can be, in particular a silicon wafer.

The organic layer can be any organic layer than can be deposited on a slice of silicon, for example, a polyimide, a thermic curing resin (epoxy basis), UV curing resin, an adhesive ("scotch") or a glue.
Note that the invention also applies in the case where there is no passivation layer. In this case it is necessary to deposit the second organic layer on the active face so as to obtain a composite structure (organic/mineral/organic). The mechanical stress due to the first organic layer thus compensates the mechanical stress due to the second organic layer.

## Claims

1. A slice of semiconductor comprising an active face and an inactive face, a passivation layer being deposited on the active face, wherein the inactive face is provided with an organic layer.

2. The slice of semiconductor according to claim 1, wherein the passivation layer is provided with a second organic layer.

3. The slice of semiconductor according to claim 1, wherein the organic layer is a polyimide.

4. The slice of semiconductor according to claim 2, wherein the second organic layer is made of a photosensitive resin.
